# EUROPEAN PATENT APPLICATION

(11) **EP 1 806 771 A1**
(43) Date of publication of application: **11.07.2007**
(21) Application number: 05778485.2
(22) Date of filing: 07.09.2005
(51) Int. Cl.: H01L 21/027, G01B 11/00, G03F 7/20, H01L 21/68

(54) **EXPOSURE DEVICE AND DEVICE MANUFACTURING METHOD**

(30) Priority: 08.10.2004 JP 2004296375
(71) Applicant: NIKON CORPORATION, Tokyo 100-8331 (JP)
(72) Inventor: ARAI, Dai, iyoda-ku, Tokyo 1008331; (JP)
(74) Representative: Hooiveld, Arjen Jan Winfried
(86) International application number: PCT/JP2005/016379
(87) International publication number: WO 2006/040890

(57) **Abstract**

An exposure apparatus equipped with a measurement stage that is provided with various measuring instruments disposed in a relationship wherein measurement accuracy is not lowered, and a device manufacturing method using the exposure apparatus are provided. An exposure apparatus according to the present invention is equipped with a measurement stage provided independent of a wafer stage that holds a wafer. On a measurement table (MTB) held on the upper face of this measurement stage, a reference plate (53) on which a first reference mark (FM1) being used for an aerial image measuring instrument and a second reference mark (FM2) for measuring the positional relationship of the wafer stage with respect to the projection image of the pattern of a reticle are formed is provided. This reference plate (53) and the aerial image measuring instrument are disposed adjacent to a reflection surface (51X) to which the beam from an X-axis interferometer is projected and a reflection surface (50) to which the beam from a Y-axis interferometer is projected.

## Description

### TECHNICAL FIELD

The present invention relates to an exposure apparatus for transferring a mask pattern onto a substrate, and to a device manufacturing method using the exposure apparatus.

This application claims priority to Japanese Patent Application No. 2004-296375 filed on October 8, 2004, the contents of which are incorporated herein by reference.

### BACKGROUND ART

In a lithography process which is one of the processes for manufacturing devices such as semiconductor devices, liquid crystal display devices, image pickup devices (CCDs (Charge Coupled Devices), etc.), and thin film magnetic heads, an exposure apparatus is used to exposure-transfer the pattern of a reticle serving as a mask onto a wafer (or a glass plate, etc.) serving as a substrate and coated with a photoresist via a projection optical system. As this exposure apparatus, a one-shot exposure type (stationary exposure type) projection exposure apparatus, such as a stepper, a scanning exposure type projection exposure apparatus (scanning exposure apparatus), such as a scanning stepper, or the like is used.

For the purpose of coping with higher integration of patterns formed on devices in recent years, it is desired that the projection optical system should have higher resolution. Therefore, attempts have been made to shorten the wavelength of the exposure light and to increase the numerical aperture (NA) of the projection optical system (i.e., to make NA larger). However, if the wavelength of the exposure light is made shorter and the NA of the projection optical system is made larger, the focus depth decreases (becomes narrower) although the resolution of the exposure apparatus is improved. Therefore, an exposure apparatus that uses a liquid immersion method as the method for substantially shortening the exposure wavelength and for increasing (widening) the focus depth compared to that in the air has become the focus of attention. As an exposure apparatus that uses this liquid immersion method, for example, as disclosed in Patent Document 1 described below, an exposure apparatus that carries out exposure while the space between the lower face of the projection optical system and the surface of the substrate is locally filled with water or another liquid, such as an organic solvent, is known. This exposure apparatus improves the resolution and increases the focus depth by using the fact that the wavelength of the exposure light in the liquid is 1/n (n: the refractive index of the liquid, approximately 1.2 to 1.6) of the wavelength thereof in the air.

Furthermore, in recent years, as disclosed in Patent Documents 2 and 3 described below, an exposure apparatus has also been suggested which is provided with a stage (measurement stage) configured so as to be movable in a two-dimensional plane independent of the substrate stage and equipped with various measuring instruments being used for measurement. In the case that this measurement stage is used, only minimal components should be installed on the substrate stage when the substrate is exposed. Therefore, the substrate stage can be made smaller in size and lighter in weight, and the drive mechanism (motor) for driving the substrate stage can be made smaller in size. The amount of heat generation from the drive mechanism can be reduced, and as a result, the thermal deformation and the decrease in exposure accuracy of the substrate stage can be reduced as much as possible.
[Patent Document 1]
   PCT International Patent Publication No. WO 99/49504
[Patent Document 2]
   Japanese Unexamined Patent Application, Publication No. H11-135400
[Patent Document 3]
   Japanese Unexamined Patent Application, Publication No. H03-211812

### DISCLOSURE OF INVENTION

### PROBLEMS TO BE SOLVED BY THE INVENTION

The accuracy required for each measuring instrument provided for the above-mentioned measurement stage is different for each measuring instrument, and the measuring instruments are completely different in size and characteristic changes due to environmental variation. Furthermore, some measuring instruments themselves generate heat. For example, in the case that an off-axis type alignment sensor is provided as a position measurement device (alignment sensor) for measuring the position information of a mark formed on a substrate, since it is necessary to extremely strictly control a baseline value (for example, the distance between the center of the projection image projected using the projection optical system and the center of the measurement view of the alignment sensor), the measuring instrument for measuring the baseline value is required to have very high measurement accuracy. On the other hand, the measuring instruments for measuring the amount, illuminance and illuminance irregularity of exposure light to be irradiated onto the substrate stage via the projection optical system have themselves characteristics of generating heat.

In addition to the various measuring instruments described above, a drive mechanism (motor) for moving the measurement stage in a two-dimensional plane is provided in the measurement stage. Since this drive mechanism is a fundamental means regarding the movement of the measurement stage, it is difficult to change the configuration thereof. Furthermore, since the drive mechanism is a heat source, there is a fear that the heat generated from the drive mechanism adversely affects the measuring instruments provided for the measurement stage and that the thermal deformation of the measurement stage lowers the measurement accuracy of the measuring instruments. It is therefore necessary that the measuring instruments of the measurement stage be disposed in the measurement stage in comprehensive consideration of the measurement accuracy, size and characteristics required for each measuring instrument, and the positional relationship to the drive mechanism.

In consideration of the above-mentioned circumstances, the present invention is intended to provide an exposure apparatus equipped with a measurement stage in which various measuring instruments are disposed in a relationship so that measurement accuracy is not lowered, and to provide a device manufacturing method using the exposure apparatus.

### MEANS FOR SOLVING THE PROBLEM

The present invention adopts the following configurations described in embodiments and corresponding to the respective drawings. However, the letter or numeral parenthesized and assigned to each element designates only an example of the element and does not limit the element.

For the purpose of solving the above-mentioned problems, an exposure apparatus according to the present invention is an exposure apparatus (EX) that exposes a substrate (W) mounted on a movable substrate stage (WST) with a pattern via a projection optical system (PL), including a measurement stage (MST) being movable independent of the substrate stage; and a position detector (42, 44) that directs a beam to a reflection member (50, 51X) provided on the measurement stage and detects the position of the measurement stage, wherein an aerial image measuring instrument (55) that measures an aerial image projected using the projection optical system and a reference mark (FM1, FM11, FM12) for measurement of the positional relationship of the substrate stage with respect to the projection image of the pattern are disposed adjacent to the reflection member of the measurement stage.

According to this invention, the positional relationship between the projection image of the pattern projected using the projection optical system and the substrate stage is measured using the aerial image measuring instrument and the reference mark disposed near the reflection member to which a beam from the position detector is projected.

In addition, another exposure apparatus according to the present invention is an exposure apparatus (EX) that exposes a substrate (W) mounted on a movable substrate stage (WST) with a pattern via a projection optical system (PL), including a measurement stage (MST) being movable independent of the substrate stage; a detector (62) that is provided on the measurement stage and detects information regarding exposure energy; and a position detector (42, 44) that directs a beam to a reflection member (50, 51X) provided on the measurement stage and detects the position of the measurement stage, wherein an aerial image measuring instrument that measures an aerial image projected using the projection optical system is disposed on the measurement stage closer to the reflection member than the detector.

According to this invention, the positional relationship between the projection image of the pattern projected using the projection optical system and the substrate stage is measured using the aerial image measuring instrument disposed closer to the reflection member to which a beam from the position detector is projected than the detector for detecting information regarding exposure energy.

Furthermore, still another exposure apparatus according to the present invention is an exposure apparatus (EX) that exposes a substrate (W) mounted on a movable substrate stage (WST) with a pattern via a projection optical system (PL), including a measurement stage (MST) being movable independent of the substrate stage; an aberration detector (59) that is provided on the measurement stage and detects the aberration information of the projection optical system; and a position detector (42, 44) that directs a beam to a reflection member (50, 51 X) provided on the measurement stage, wherein an aerial image measuring instrument (55) that measures an aerial image projected using the projection optical system is disposed on the measurement stage closer to the reflection member than the aberration detector.

According to this invention, the positional relationship between the projection image of the pattern projected using the projection optical system and the substrate stage is measured using the aerial image measuring instrument disposed closer to the reflection member to which a beam from the position detector is projected than the aberration detector for detecting the aberration information of the projection optical system.

A device manufacturing method according to the present invention is characterized in that the method includes a process for transferring the pattern of a device onto a substrate using the exposure apparatus described in either one of the above.

### EFFECTS OF THE INVENTION

Since the aerial image measuring instrument and the reference mark are disposed near the reflection member, errors in the relative positional relationship among these hardly occur, whereby the present invention is effective in that the positional relationship between the projection image of the pattern and the substrate stage can be measured with high accuracy without lowering the measurement accuracy.

### BRIEF DESCRIPTION OF THE DRAWINGS

FIG. 1 is a side view showing the schematic configuration of the exposure apparatus according to an embodiment of the present invention.
FIG. 2 is a perspective view showing the configuration of the stage device.
FIG. 3A is a perspective view illustrating a first drive system provided for the wafer stage.
FIG. 3B is another perspective view illustrating the first drive system provided for the wafer stage.
FIG. 4 is a top view showing the measurement stage.
FIG. 5A is a view showing an example of a first reference mark.
FIG. 5B is a view showing an example of a second reference mark.
FIG. 6 is a sectional view showing the configuration of a part of an aerial image measuring instrument.
FIG. 7 is a block diagram showing the configuration of the control system of the exposure apparatus.
FIG. 8A is a plan view illustrating parallel processing of the wafer stage and the measurement stage.
FIG. 8B is another plan view illustrating parallel processing of the wafer stage and the measurement stage.
FIG. 9A is another plan view illustrating parallel processing of the wafer stage and the measurement stage.
FIG. 9B is another plan view illustrating parallel processing of the wafer stage and the measurement stage.
FIG. 10A is a plan view showing the positional relationship between the wafer stage and the measurement stage when baseline values are measured.
FIG. 10B is another plan view showing the positional relationship between the wafer stage and the measurement stage when baseline values are measured.
FIG. 11 is a flowchart showing an example of a process for manufacturing micro devices.

### DESCRIPTION OF THE REFERENCE SYMBOLS

42 : X-AXIS INTERFEROMETER, 44 : Y-AXIS INTERFEROMETER, 50 : REFLECTION SURFACE (REFLECTION MEMBER, FIRST REFLECTION MEMBER), 51X : REFLECTION SURFACE (REFLECTION MEMBER, SECOND REFLECTION MEMBER), 51 Y : REFLECTION SURFACE (THIRD REFLECTION MEMBER), 53 : REFERENCE PLATE (MEASUREMENT PATTERN), 55 : AERIAL IMAGE MEASURING INSTRUMENT, 62 : EXPOSURE DETECTOR (DETECTOR), EX : EXPOSURE APPARATUS, FM1, FM11, FM12 : FIRST REFERENCE MARK (REFERENCE MARK), MST : MEASUREMENT STAGE, MTB : MEASUREMENT TABLE (PLATE PORTION), PL : PROJECTION OPTICAL SYSTEM, W : WAFER (SUBSTRATE), WST : WAFER STAGE (SUBSTRATE STAGE)

### BEST MODE FOR CARRYING OUT THE INVENTION

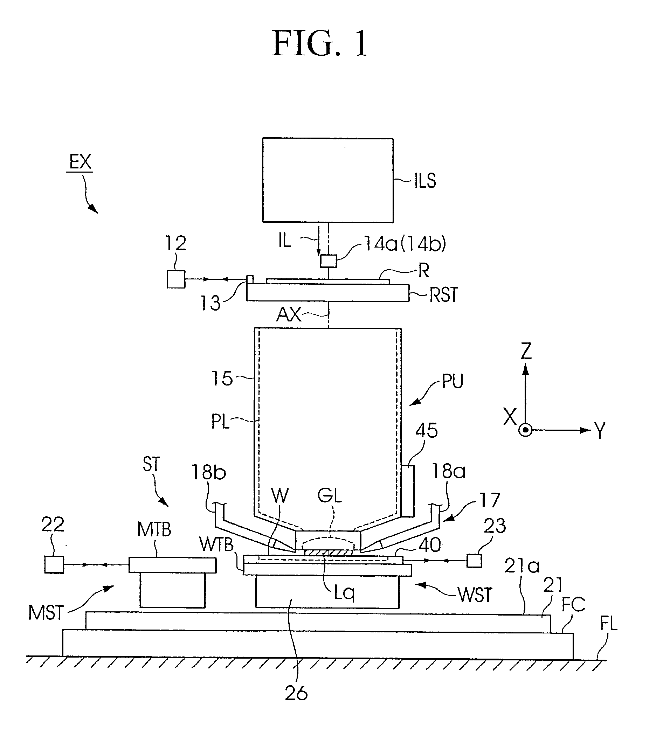

An exposure apparatus and a device manufacturing method according to an embodiment of the present invention will be described below in detail with reference to the drawings. FIG. 1 is a side view showing the schematic configuration of the exposure apparatus according to an embodiment of the present invention. The exposure apparatus EX shown in FIG. 1 is a step-and-scan type scanning-exposure type exposure apparatus in which a pattern formed on a reticle R is transferred sequentially to a wafer W while the reticle R serving as a mask and the wafer W serving as a substrate are moved relatively with respect to a projection optical system PL shown in FIG.1.

In the following descriptions, an XYZ orthogonal coordinate system is set in the drawings as necessary, and the positional relationship of the respective members are described with reference to this XYZ orthogonal coordinate system. In the XYZ orthogonal coordinate system shown in FIG. 1, the X-axis and the Y-axis are set so as to be included in a plane that is parallel with the movement face of the wafer W, and the Z-axis is set in a direction along the optical axis AX of the projection optical system PL. In addition, in this embodiment, the direction (scanning direction) in which the reticle R and the wafer W are moved synchronously is set in the Y direction.

As shown in FIG. 1, the exposure apparatus EX according to this embodiment includes an illumination optical system ILS; a reticle stage RST for holding a reticle R serving as a mask; a projection unit PU; a stage apparatus ST having a wafer stage WST serving as a substrate stage for holding a wafer W serving as a substrate and a measurement stage MST; and a control system for controlling these. The illumination optical system ILS illuminates a slit-like illumination area on the reticle R, defined using a reticle blind, not shown, at nearly uniform illuminance using an illumination light (exposure light) IL. As the illumination light IL, an ArF excimer laser light (wavelength: 193 nm) is used as an example.

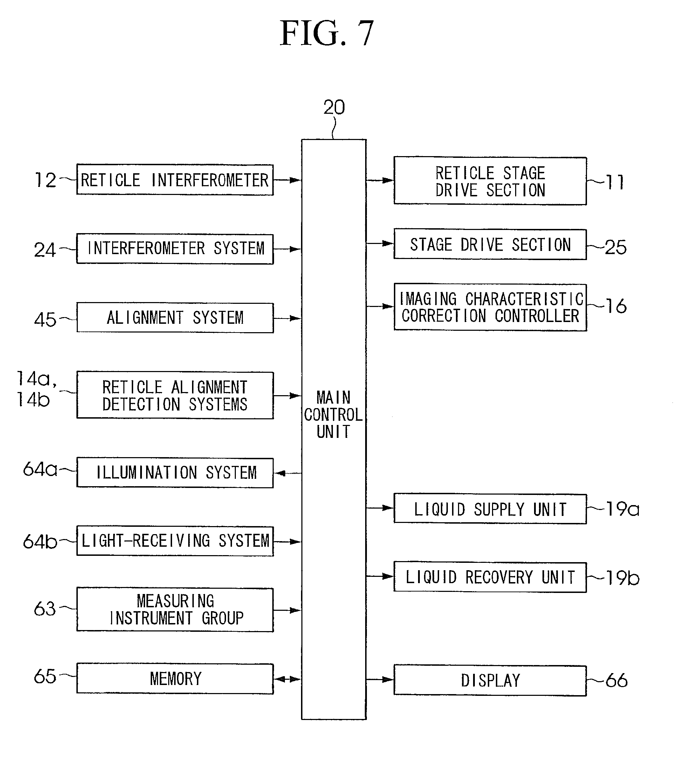

On the reticle stage RST, the reticle R, on the pattern face (the face on the -Z side in FIG. 1) of which a pattern is formed, is held by vacuum suction, for example. The reticle stage RST is configured so as to be minutely drivable in the XY plane perpendicular to the optical axis (coincident with the optical axis AX of the projection optical system PL described later) of the illumination optical system ILS and drivable in the scanning direction (Y direction) at a designated scanning speed using a reticle stage drive section 11 (not shown in FIG. 1, see FIG. 7) including linear motors, for example.

The position (including the rotation around the Z-axis) of the reticle stage RST in the stage movement face is detected at all times at a resolution of approximately 0.5 to 1 nm, for example, using a laser interferometer (hereinafter referred to as a reticle interferometer) 12 via a moving mirror 13 (in practice, a Y moving mirror having a reflection surface orthogonal to the Y-axis and an X moving mirror having a reflection surface orthogonal to the X-axis are provided). The measured values of this reticle interferometer 12 are output to a main control unit 20 (not shown in FIG. 1, see FIG. 7); the main control unit 20 calculates the position of the reticle stage RST in the X direction, Y direction and θZ direction (the rotation direction around the Z-axis) on the basis of the measured values of the reticle interferometer 12, and controls the reticle stage drive section 11 on the basis of the results of the calculation, thereby controlling the position (and speed) of the reticle stage RST.

Above the reticle stage RST, a pair of reticle alignment detection systems 14a and 14b, formed of a TTR (Through The Reticle) alignment system using light, having an exposure wavelength, is provided with a predetermined distance therebetween in the X direction. The reticle alignment detection systems 14a and 14b are used to simultaneously observe the conjugated images of a pair of reticle alignment marks on the reticle R and a pair of reference marks (hereinafter referred to as a first prior reference marks) on the measurement stage MST corresponding thereto via the projection optical system PL. As the reticle alignment detection systems 14a and 14b, those similarly configured, such as that disclosed in Japanese Unexamined Patent Application, Publication No. H7-176468 (corresponding US Patent No. 5,646,413), are used.

The projection unit PU includes a lens barrel 15 and the projection optical system PL including a plurality of optical elements held inside the lens barrel 15 so as to have a predetermined positional relationship. As the projection optical system PL, a refracting optical system including multiple lenses (lens elements) having a common optical axis AX in the Z direction, for example, are used. Furthermore, specific multiple lenses, not shown, among the multiple lenses constituting the projection optical system PL are controlled using an imaging characteristic correction controller 16 (see FIG. 7) on the basis of commands from the main control unit 20, thereby being capable of adjusting the optical characteristics (including imaging characteristics) of the projection optical system PL, such as magnification, distortion, coma aberration and field curvature (including field inclination).

Furthermore, for the purpose of carrying out exposure using the liquid immersion method, the exposure apparatus EX according to this embodiment is provided with a liquid supply nozzle 18a and a liquid recovery nozzle 18b constituting a liquid immersion unit 17 near a lens GL (hereinafter also referred to as a front lens) serving as an optical element constituting the projection optical system PL and disposed on the image-most plane side (on the side of the wafer W). One end of a supply pipe, not shown, is connected to a liquid supply unit 19a (not shown in FIG. 1, see FIG. 7), and the other end thereof is connected to the liquid supply nozzle 18a. One end of a recovery pipe, not shown, is connected to a liquid recovery unit 19b (not shown in FIG. 1, see FIG. 7), and the other end thereof is connected to the liquid recovery nozzle 18b.

As the above-mentioned liquid, ultrapure water (hereinafter simply referred to as "water" unless otherwise necessary) through which the ArF excimer laser beam (wavelength: 193 nm) passes is herein used. Ultrapure water is advantageous because it can easily be obtained in large quantity from semiconductor manufacturing plants and the like and because it does not adversely affect a photoresist coated on the wafer W, optical lenses, etc. The refraction index n of water is nearly 1.44, and in this water the wavelength of the illumination light IL is shortened to 193 nm x 1/n = approximately 134 nm.

A valve connected to the supply pipe is opened a predetermined opening amount according to a command from the main control unit 20, and the liquid supply unit 19a supplies water to the space between the front lens GL and the wafer W via the liquid supply nozzle 18a. In addition, a valve connected to the recovery pipe is opened a predetermined opening amount according to a command from the main control unit 20, and the liquid recovery unit 19b recovers water from the space between the front lens GL and the wafer W via the liquid recovery nozzle 18b to the inside of the liquid recovery unit 19b (liquid tank). At this time, the main control unit 20 issues the commands to the liquid supply unit 19a and the liquid recovery unit 19b so that the amount of water supplied from the liquid supply nozzle 18a to the space between the front lens GL and the wafer W is always equal to the amount of water recovered via the liquid recovery nozzle 18b. Therefore, a constant amount of water Lq (see FIG. 1) is held in the space between the front lens GL and the wafer W. The water Lq held in the space between the front lens GL and the wafer W is always replaced.

As described above, the liquid immersion unit 17 provided for the exposure apparatus of this embodiment is a local liquid immersion unit including the liquid supply unit 19a, the liquid recovery unit 19b, the supply pipe, the recovery pipe, the liquid supply nozzle 18a and the liquid recovery nozzle 18b. Even in the case that the measurement stage MST is positioned below the projection unit PU, it is possible to fill the space between the measurement table MTB and the front lens GL with water in a way similar to that described above.

The stage device ST includes, for example, a frame caster FC disposed on the floor face FL of a semiconductor plant; a base 21 provided on the frame caster FC; the wafer stage WST and the measurement stage MST disposed above the base 21 so as to move along the upper face (movement face) 21a of the base 21; an interferometer system 24 (see FIG. 7) serving as a position detector and including interferometers 22 and 23 for detecting the positions of the states WST and MST; and a stage drive section 25 (see FIG. 7) for driving the stages WST and MST. The above-mentioned wafer stage WST moves while holding the wafer W so that the pattern of the reticle R is exposure-transferred to the wafer W. On the other hand, while the wafer stage WST is positioned at the loading position so that the wafer W is replaced, the measurement stage MST is positioned below the projection optical system PL and carries out various measurements.

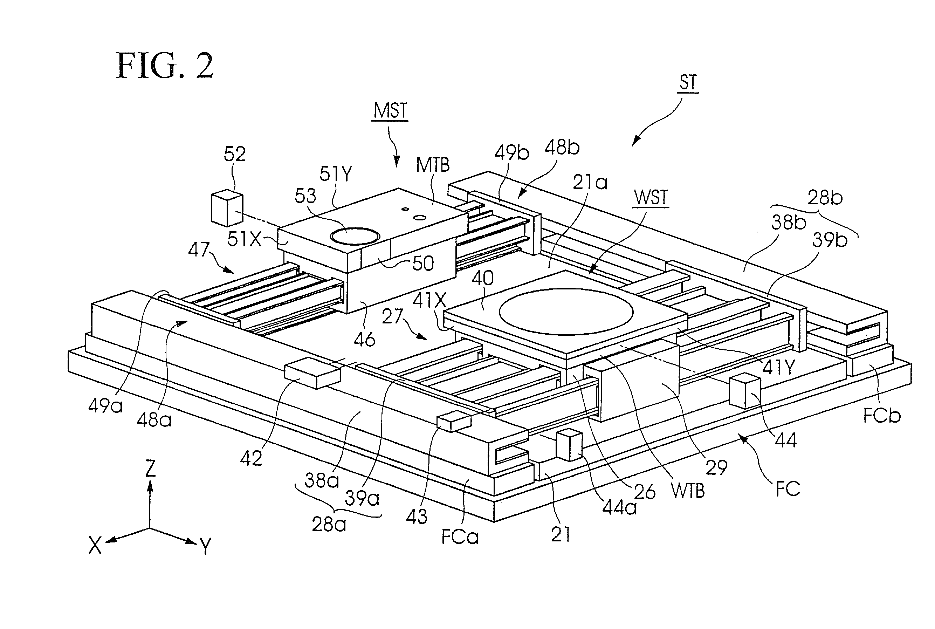

Next, the configuration of the stage device ST will be described in detail. FIG. 2 is a perspective view showing the configuration of the stage device ST. As shown in FIG. 2, the frame caster FC has the shape of a generally flat plate on which protrusion portions FCa and FCb protruding upward are formed integrally near the end portions on one side and the other side in the X direction, the longitudinal direction thereof being the Y direction. The base (platen) 21 is disposed in an area held between the protrusion portions FCa and FCb of the frame caster FC. The upper face 21a of the base 21 is finished so as to have a very high degree of flatness and serves as a guide face when the wafer stage WST and the measurement stage MST move along the XY plane.

As shown in FIG. 2, the wafer stage WST includes a wafer stage body 26 disposed above the base 21 and a wafer table WTB mounted on the wafer stage body 26. The wafer stage body 26 is formed of hollow members having a rectangular frame shape in cross section and extending in the X direction. On the lower face of the wafer stage body 26, such a self-weight canceling mechanism as described in Japanese Patent Application No. 2004-215439 that was applied earlier by the applicant of the present application is provided. This self-weight canceling mechanism has a support portion that applies inner pressure to bellows to support the wafer stage WST and an air bearing portion that floats the wafer stage WST from the movement face 21 a so as to be opposed to the movement face 21 a serving as a guide face.

In addition, the wafer stage WST is provided with a first drive system 27 for driving the wafer stage body 26 in the X direction by long strokes and for minutely driving the wafer stage body 26 in the Y direction, the Z direction, the θx direction (the rotation direction around the X-axis), the θy direction (the rotation direction around the Y-axis) and the θz direction (the rotation direction around the Z-axis); and second drive systems 28a and 28b for driving the wafer stage body 26 and the first drive system 27 in the Y direction by long strokes. Furthermore, the wafer stage WST is provided with a tube carrier 29 for performing a constant-speed motion in the X direction and a six-degree-of-freedom pipe, not shown, for transmitting vacuum or pneumatic power from the tube carrier 29 to the wafer stage body 26 in a non-contact state. The reason why the tube carrier 29 performs the constant-speed motion in the X direction is to reduce the influence of the reaction force generated by the driving of the tube carrier 29 on the wafer stage body 26.

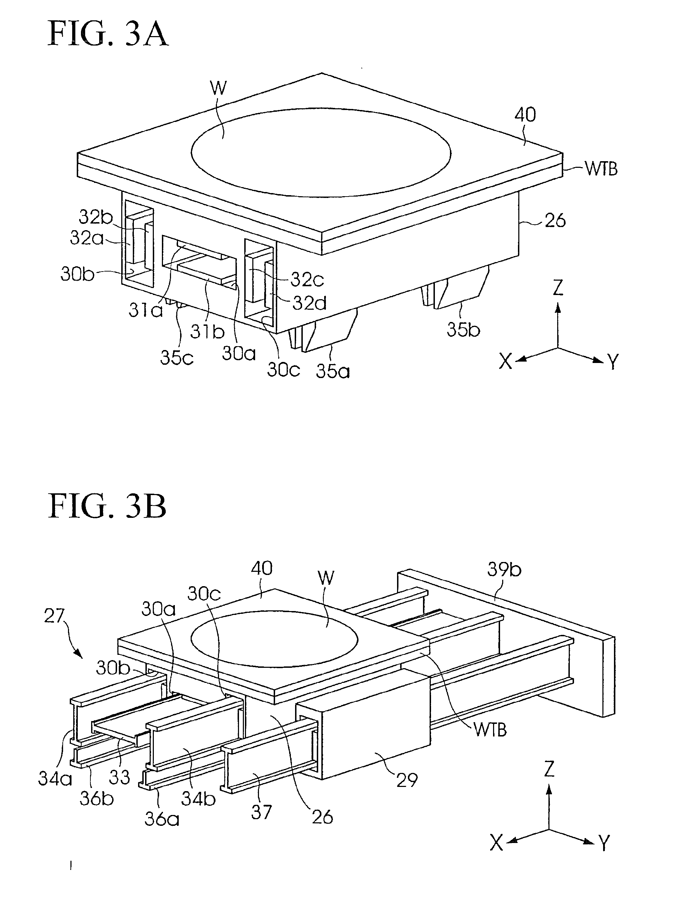

FIGS. 3A and 3B are perspective views illustrating the first drive system 27 provided for the wafer stage WST. As shown in FIG. 3A, three openings 30a to 30c are provided on the +X direction end face of the wafer stage body 26, and three openings, not shown, respectively corresponding to the openings 30a to 30c, are provided on the -X direction end face of the wafer stage body 26. A pair of permanent magnets 31 a and 31b serving as Y axis movers is provided in the opening 30a. In addition, a pair of permanent magnets 32a and 32b serving as X-axis movers are provided in the opening 30b; and a pair of permanent magnets 32c and 32d serving as X-axis movers are provided similarly in the opening 30c.

On the other hand, as shown in FIG. 3B, a Y-axis stator 33 provided with multiple coils is installed so as to pass through the wafer stage body 26 in the X direction via the opening 30a, and X-axis stators 34a and 34b provided with multiple coils are installed so as to pass through the wafer stage body 26 in the X direction via the openings 30b and 30c, respectively. The above-mentioned Y-axis stator 33 cooperates with the pair of permanent magnets 31a and 31b provided in the opening 30a to minutely drive the wafer stage body 26 in the Y direction.

Furthermore, the above-mentioned X-axis stators 34a and 34b cooperate with the pair of permanent magnets 32a and 32b and the pair of permanent magnets 32c and 32d to drive the wafer stage body 26 in the X direction by long strokes. Still further, the Lorentz force generated using the above-mentioned pair of permanent magnets 32a and 32b and the X-axis stator 34a is made different from the Lorentz force generated using the pair of magnets 32c and 32d and the X-axis stator 34b, whereby the wafer stage body 26 can be rotated in the θz direction. In other words, the first drive system 27 includes a moving-magnet type linear motor having the X-axis stator 34a and the pair of magnets 32a and 32b, and a moving-magnet type linear motor having the X-axis stator 34b and the pair of magnets 32c and 32d. Although an example provided with moving-magnet type linear motors is taken and described herein, moving-coil type linear motors may also be provided. In addition, as described above, the wafer stage WST is a guideless stage having no guide member for guiding its movement in the X direction.

Furthermore, as shown in FIG. 3A, below the wafer stage body 26, four permanent magnets 35a to 35d (the permanent magnet 35d is not shown) are provided so as to serve as Z-axis movers. Moreover, as shown in FIG. 3B, a Z-axis stator 36a provided with multiple coils and extending in the X direction, corresponding to the permanent magnets 35a and 35b, is provided. A Z-axis stator 36b provided with multiple coils and extending in the X direction, corresponding to the permanent magnets 35c and 35d, is provided. These Z-axis stators 36a and 36b cooperate with the permanent magnets 35a and 35b and the permanent magnets 35c and 35d, respectively, and generate a drive force in the Z direction. The wafer stage body 26 can be driven in the Z direction, the θx direction and the θy direction by controlling the currents to be supplied to the coils provided for the Z-axis stators 36a and 36b. Furthermore, a stator 37 extending in the X direction is also provided to drive the tube carrier 29 in the X direction. Both ends of each of the Y-axis stator 33, the X-axis stators 34a and 34b, the Z-axis stators 36a and 36b and the stator 37 described above are secured to the movers 39a and 39b constituting the second drive systems 28a and 28b, respectively.

Returning to FIG. 2, above the protrusion portions FCa and FCb of the frame caster FC, Y-axis stators 38a and 38b constituting the second drive systems 28a and 28b and extending in the Y direction are disposed, respectively. These Y-axis stators 38a and 38b are supported so as to be floated via a predetermined clearance above the protrusion portions FCa and FCb using gas static pressure bearings, not shown, such as air bearings, provided on the lower faces thereof, respectively. This configuration is used so that the stators 38a and 38b are moved as Y-direction Y-counter masses in the opposite direction by the reaction force generated by the Y direction movements of the wafer stage WST and the measurement stage MST, and so that the reaction force is canceled by the law of conservation of momentum.

Between the stators 38a and 38b, the wafer stage body 26, etc., described referring to FIGS. 3A and 3B are disposed, and the movers 39a and 39b secured to both ends of each of the Y-axis stator 33, the X-axis stators 34a and 34b, the Z-axis stators 36a and 36b and the stator 37 are inserted from the inside of the stators 38a and 38b, respectively. The stators 38a and 38b are provided with permanent magnets arranged in the Y direction, and the movers 39a and 39b are provided with coils arranged in the Y direction. In other words, the second drive systems 28a and 28b are provided with moving-coil type linear motors for driving the wafer stage WST in the Y direction. Although an example provided with moving-coil type linear motors is taken and described herein, moving-magnet type linear motors may also be provided.

The wafer stage WST is a guideless stage having no guide member for guiding its Y direction movement, except for the electromagnetic coupling between the stator 38a and the mover 39a and the electromagnetic coupling between the stator 38b and the mover 39b. The reaction force generated when the wafer stage WST is driven in the X direction is transmitted to X-counter masses, not shown, via the electromagnetic couplings between the stators 38a and 38b and the movers 39a and 39b provided for the second drive systems 28a and 28b. The X-counter masses are provided between the protrusion portions FCa and FCb of the frame caster FC and the stators 38a and 38b, configured so as to be movable in the X direction while supporting the stators 38a and 38b serving as the Y-direction counter masses, and move in a direction opposite the X direction movement of the wafer stage WST, thereby canceling the reaction force generated when the wafer stage WST is driven in the X direction.

On the wafer table WTB, a wafer holder 40 for holding the wafer W is provided. The wafer holder 40 includes a plate-like body portion and an auxiliary plate having liquid repellency (water repellency), secured to the upper face of this body portion and having a circular opening that is formed in the center and has a diameter larger than that of the wafer W. In the area of the body portion inside the circular opening of this auxiliary plate, numerous (multiple) pins are disposed, and the wafer W is vacuum-sucked in a state of being supported using the numerous pins. In this case, in the state in which the wafer W is vacuum-sucked, the auxiliary plate is formed so that the surface of the wafer W and the surface of the auxiliary plate have almost the same height. The surface of the wafer table WTB may be provided with liquid repellency, instead of providing the auxiliary plate.

In addition, as shown in FIG. 2, a reflection surface 41X being orthogonal to the X direction (extending in the Y direction) is formed by mirror polishing at one X-direction end (the +X end) of the wafer table WTB, and a reflection surface 41 Y being orthogonal to the Y direction (extending in the X direction) is formed similarly by mirror polishing at one Y-direction end (the +Y end) of the wafer table WTB. To these reflection surfaces 41X and 41Y, interferometer beams (beams) from X-axis interferometers 42 and 43 and Y-axis interferometers 44 and 44a constituting the interferometer system 24 (see FIG. 7) are projected. The X-axis interferometers 42 and 43 and the Y-axis interferometers 44 and 44a shown in FIG. 2 are collectively shown in FIG. 1 as the interferometer 23.

The X-axis interferometers 42 and 43 and the Y-axis interferometers 44 and 44a receive reflected light from the reflection surfaces 41X and 41Y, respectively, thereby detecting displacements in the measurement directions from the reference positions (generally, a fixed mirror is disposed on the side face of the projection unit PU or on the side face of an off-axis type alignment system 45 (see FIG. 1 and FIG. 7) disposed on the +Y side of the projection optical system PL, and the side face is used as the reference face) of the reflection surfaces 41X and 41Y Instead of the configuration in which the reflection surfaces 41X and 41Y are formed on the end faces of the wafer table WTB, it may also be possible to have a configuration in which a Y movement mirror having a reflection surface extending in the X direction and an X movement mirror having a reflection surface extending in the Y direction are respectively provided on the upper face of the wafer table WTB.

The X-axis interferometer 42 has a measurement axis passing through the projection center (the optical axis AX, see FIG. 1) of the projection optical system PL and being parallel with the X-axis and a measurement axis passing through the measurement view center of the alignment system 45 and being parallel with the X-axis; the interferometer detects the X direction position of the wafer table WTB using the measurement axis passing through the projection center of the projection optical system PL at the time of exposure, and measures the X direction position of the wafer table WTB using the measurement axis passing through the measurement view center of the alignment system 45 at the time of enhanced global alignment (EGA). Furthermore, the X-axis interferometer 42 measures the X direction position of the measurement table MTB by appropriately using the two measurement axes depending on the measurements of baseline values and the measurements obtained using various measuring instruments provided for the measurement stage MST. In other words, the X-axis interferometer 42 can measure the X direction position of the wafer table WTB or the measurement table MTB using the projection center position and the center position of alignment in the Y direction. The baseline value is a measure indicating the positional relationship of the wafer stage WST with respect to the projected image of a pattern projected using the projection optical system PL, and more specifically is the distance between the projection center of the projection optical system PL and the measurement view center of the alignment system 45.

The Y-axis interferometer 44 has a measurement axis connecting the projection center (the optical axis AX, see FIG. 1) of the projection optical system PL and the measurement view center of the alignment system 45 and being parallel with the Y axis, and mainly detects the Y direction position of the wafer table WTB. Furthermore, the Y-axis interferometer 44 detects the Y direction position of the measurement table MTB while the wafer stage WST is positioned at the loading position so that the wafer W is replaced, although this is detailed later. The X-axis interferometer 43 and the Y-axis interferometer 44a described above auxiliarily detect the position of the wafer stage WST inside the XY plane while the wafer stage WST is positioned at the loading position so that the wafer W is replaced.

The configuration of the measurement stage MST is almost similar to that of the wafer stage WST, except for the tube carrier 29 and a six-degree-of-freedom pipe, not shown. In other words, as shown in FIG. 2, the measurement stage MST includes a measurement stage body 46 disposed above the base 21 and the measurement table MTB mounted on the measurement stage body 46 and serving as a plate portion. In addition, the measurement stage further includes a first drive system 47 for driving the measurement stage body 46 in the X direction by long strokes and for minutely driving the measurement stage body 46 in the Y, Z, θx, θy and θz directions, and second drive systems 48a and 48b for driving the measurement stage body 46 and the first drive system 47 by long strokes in the Y direction. The measurement stage body 46 is formed of hollow members having a rectangular frame shape in cross section and extending in the X direction.

As in the first drive system 27 provided for the wafer stage WST, the first drive system 47 includes a pair of permanent magnets provided for each of three openings formed in the ±X end faces of the measurement stage body 46, one X-axis stator provided with multiple coils so as to pass through the measurement stage body 46 in the X direction via each of the openings, and two Y-axis stators. These permanent magnets, the X-axis stator and the Y-axis stator drive the measurement stage body 46 in the X direction by long strokes, minutely drive the measurement stage body 46 in the Y direction, and rotate the measurement stage body 46 in the θz direction. Furthermore, the first drive system 47 includes permanent magnets (permanent magnets similar to the permanent magnets 35a to 35d provided for the wafer stage body 26 and shown in FIGS. 3A and 3B) provided on the lower face of the measurement stage body 46, and Z-axis stators (Z-axis stators similar to the Z-axis stators 36a and 36b) for generating a thrust force in cooperation with these permanent magnets. The permanent magnets and the Z-axis stators can drive the measurement stage body 46 in the Z, θx and θy directions. Although an example in which the first drive system 47 is provided with moving-magnet type linear motors is taken and described herein, the first drive system 47 may also be provided with moving-coil linear motors.

The second drive systems 48a and 48b include the stators 38a and 38b, and movers 49a and 49b secured to both ends of each of the X-axis stator passing through the measurement stage body 46 in the X direction, the Y-axis stator and the Z-axis stator disposed (in the -Z direction) below the measurement stage body 46, and the movers 49a and 49b are inserted from the inside of the stators 38a and 38b, respectively. The movers 49a and 49b are provided with coils arranged in the Y direction, and the coils cooperate with the stators 38a and 38b provided with permanent magnets arranged in the Y direction to generate a thrust force in the Y direction. In other words, the second drive systems 48a and 48b are provided with moving coil type linear motors for driving the measurement stage MST in the Y direction. Although an example provided with moving-coil linear motors is taken and described herein, moving-magnet type linear motors may also be provided.

The first drive system 27 and the second drive systems 28a and 28b for driving the wafer stage WST, and the first drive system 47 and the second drive systems 48a and 48b for driving the measurement stage MST described above constitute the stage drive section 25 shown in FIG. 7. Each of the various drive mechanisms constituting the stage drive section 25 is controlled using the main control unit 20 shown in FIG. 7. In other words, the main control unit 20 controls the movement of the measurement stage MST before the wafer W is exposed and the movement of the wafer stage WST during exposure via the stage drive section 25, for example.

The measurement table MTB serving as the plate portion is made of a low thermal expansion material, such as Zerodur (registered trademark) made by SCHOTT Nippon K.K., and the upper face thereof has liquid repellency (water repellency). The measurement table MTB is held on the measurement stage body 46 by vacuum suction, for example, and configured so as to be replaceable. The height of the surface of the measurement table MTB is set so as to be almost the same as the height of the surface of the wafer holder 40 provided on the wafer table WTB. In addition, as shown in FIG. 2, a reflection surface 50 orthogonal to the Y direction (extending in the X direction) is formed as a first reflection member by mirror polishing at one end (the +Y end) of the measurement table MTB in the Y direction. Furthermore, a reflection surface 51X orthogonal to the X direction (extending in the Y direction) is formed as a second reflection member by mirror polishing at one end (the +X end) of the measurement table MTB in the X direction, and a reflection surface 51 Y being orthogonal to the Y direction (extending in the X direction) is formed similarly as a third reflection member by mirror polishing at one end (the -Y end) of the measurement table MTB in the Y direction.

While the wafer stage WST is positioned at the loading position so that the wafer W is replaced, an interferometer beam (beam) from the Y-axis interferometer 44 is projected to the reflection surface 50. Furthermore, to the reflection surfaces 51X and 51 Y, interferometer beams (beams) from the X-axis interferometer 42 and a Y-axis interferometer 52 constituting the interferometer system 24 (see FIG. 7) are projected. The X-axis interferometer 42 and the Y-axis interferometer 52 shown in FIG. 2 are collectively shown in FIG. 1 as the interferometer 22.

The X-axis interferometer 42 and the Y-axis interferometer 52 receive reflected light from the reflection surfaces 51X and 51 Y, respectively, thereby detecting displacements in the measurement directions from the reference positions (generally, a fixed mirror is disposed on the side face of the projection unit PU or on the side face of an off-axis type alignment system 45 (see FIG. 1 and FIG. 7), and the side face is used as the reference face) of the reflection surfaces 51X and 51 Y Instead of the configuration in which the reflection surfaces 51X and 51Y are formed on the end faces of the measurement table MTB, it may also be possible to have a configuration in which a Y movement mirror having a reflection surface extending in the X direction and an X movement mirror having a reflection surface extending in the Y direction are respectively provided on the upper face of the measurement table MTB. As in the Y-axis interferometer 44, the above-mentioned Y-axis interferometer 52 has a measurement axis connecting the projection center (the optical axis AX, see FIG. 1) of the projection optical system PL and the measurement view center of the alignment system 45 and being parallel with the Y-axis, and detects the Y direction position of the measurement table MTB, except when the wafer stage WST is positioned at the loading position so that the wafer W is replaced.

Furthermore, the measurement stage MST has measuring instruments for carrying out various measurements regarding exposure. At a predetermined position on the upper face of the measurement table MTB, a reference plate 53 serving as a measurement pattern portion on which various marks being used by these measuring instruments are formed is provided. This reference plate 53 is made of a low thermal expansion material, and its upper face has liquid repellency (water repellency). The reference plate 53 is configured so as to be replaceably mounted on the measurement table MTB. Next, the arrangement of the various measuring instruments provided for the measurement stage MST will be described.

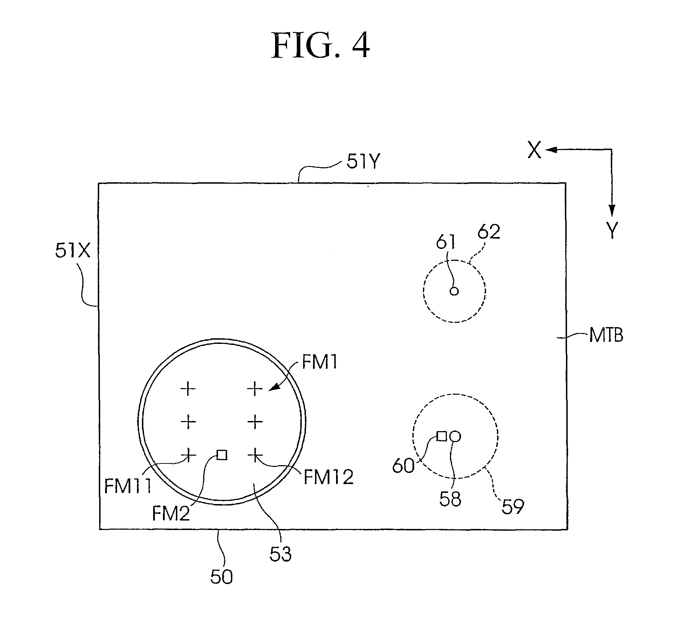

FIG. 4 is a top view showing the measurement stage MST. As shown in FIG. 4, the reference plate 53 has a circular shape, and on the upper face thereof, the above-mentioned first reference mark (hereinafter referred to as "first reference mark FM1") and another reference mark FM2 (hereinafter referred to as "second reference mark") FM2 being measured using the alignment system 45 when the baseline values are measured are formed. The reference plate 53 is herein made circular to facilitate the angle adjustment of the reference plate 53 within the face of the measurement table MTB and to prevent water being supplied to the upper face of the measurement table MTB from entering the insides of the measurement table MTB and the measurement stage MST as much as possible.

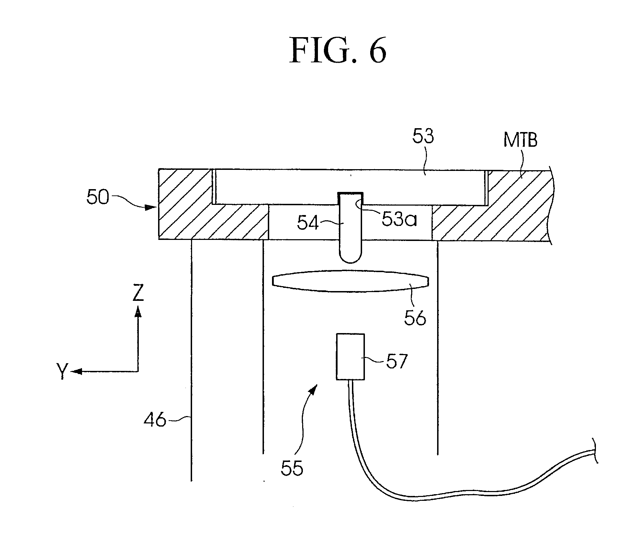

In addition, the reference plate 53 is disposed near the reflection surface 51X to which a beam from the X-axis interferometer 42 is projected and the reflection surface 50 to which a beam from the Y-axis interferometer 44 is projected. This configuration is used to reduce errors in the baseline values. In other words, the baseline values are measured on the basis of the measurement results of the first reference mark FM1 using an aerial image measuring instrument 55 (see FIG. 6) described later, the measurement results of the second reference mark FM2 in the alignment system 45, and the detection results of the X-axis interferometer 42 and the Y-axis interferometer 44. Errors in the baseline value are caused by the fluctuation in the relative positional relationship between the first reference mark FM1 and the second reference mark FM2, and the reflection surface 51X and the reflection surface 50. And the change in the relative positions owing to the thermal expansion or the like of the measurement table MTB becomes larger as the distance therebetween is longer. Therefore, errors owing to the thermal expansion or the like of the measurement table MTB are made as small as possible by disposing the first reference mark FM1 and the second reference mark FM2 near the reflection surface 51X and the reflection surface 50, whereby errors in the baseline values are reduced.

The first reference mark FM1 includes in total six marks arranged in three rows in the Y direction, each pair being disposed with a predetermined distance therebetween in the X direction. The X-direction distance between the marks constituting the first reference mark FM1 is set at a distance obtained by multiplying the spacing between a pair of reticle alignment marks formed on the reticle R by the projection magnification factor β (for example, 1/4 or 1/5) of the projection optical system PL. In addition, the shape and size of the reference mark FM1 is determined in consideration of the size of the reticle alignment marks. Among the six reference marks FM1, at the intermediate position between the pair of first reference marks FM11 and FM12 (the pair of first reference marks formed nearest the reflection surface 50), the second reference mark FM2 is formed.

The reason why the second reference mark FM2 is formed at the intermediate position between the first reference marks FM11 and FM12 formed nearest the reflection surface 50 is to make the Y-direction length of the measurement table MTB as short as possible. In other words, when the baseline value is measured, the second reference mark FM2 is required to be disposed within the measurement view of the alignment system 45 disposed on the +Y side of the projection optical system PL. Even when the baseline value is measured, water is supplied to the space between the front lens GL of the projection optical system PL and the measurement table MTB. For the purpose of receiving this water on the measurement table MTB, the length from the position at which the second reference mark FM2 is formed to the end portion of the measurement table MTB in the -Y direction is required to have at least the distance between the alignment system 45 and the area to which the water is supplied. For this reason, the Y-direction length of the measurement table MTB is made as short as possible by disposing the second reference mark FM2 at the position nearest the end portion of the measurement table MTB in the +Y direction.

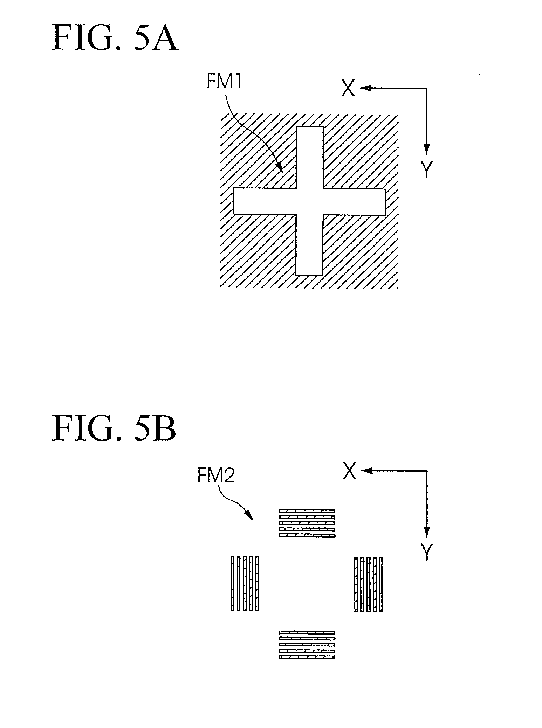

FIGS. 5A and 5B are views showing examples of the first reference mark FM1 and the second reference mark FM2. As shown in FIG. 5A, the first reference mark FM1 is a cross-like opening (slit) formed in a light-shielding area made of a metal, such as Cr (chromium). Furthermore, as shown in FIG. 5B, the second reference mark FM2 includes an X-mark in which mark groups, each consisting of mark elements where the longitudinal direction is the Y direction and the mark elements being arranged at predetermined intervals in the X direction, are spaced apart a predetermined distance in the X direction, and a Y-mark in which mark groups, each consisting of mark elements where the longitudinal direction thereof being the X direction and the mark elements being arranged at predetermined intervals in the Y direction, are spaced apart a predetermined distance in the Y direction. Each mark element of the second reference mark FM2 may be made of a metal, such as Cr (chromium), and the each mark element may be formed by forming an opening (slit) in a light-shielding area made of a metal, such as Cr (chromium).

Inside the measurement stage MST and below the reference plate 53 (in the-Z direction), a part of an aerial image measuring instrument for measuring an aerial image projected on the measurement table MTB via water using the projection optical system PL is provided. FIG. 6 is a sectional view showing the configuration of part of the aerial image measuring instrument. As shown in FIG. 6, the measurement table MTB is mounted on the measurement stage body 46 by vacuum suction, and the reference plate 53 is held by vacuum suction in the recess portion formed in the measurement table MTB. In this configuration, the measurement stage body 46 is provided with a positioning pin 54 so as not to shield the exposure light passed through the first reference mark FM1; the recess portion 53a formed at the central portion on the back side of the reference plate 53 is fitted on the tip of the positioning pin 54, and the reference plate 53 is rotated around the positioning pin 54 so as to be positioned accurately, and then the reference plate 53 is mounted on the measurement table MTB by vacuum suction.

The aerial image measuring instrument 55 includes a condenser lens 56 provided below the reference plate 53; an optical fiber 57, one end thereof being disposed at one of the focal positions of the condenser lens 56, for guiding the exposure light condensed using the condenser lens 56 to the -Y side of the measurement stage MST; and a photoelectric transducer, such as a photomultiplexer, not shown, for photoelectrically converting the exposure light guided using the optical fiber 57 and emitted from the other end thereof. As the aerial image measuring instrument 55, for example, the instrument disclosed in Japanese Unexamined Patent Application, Publication No. 2002-14005 (corresponding U.S. Patent Publication No. 2002/0041377) can be used. The photoelectric transducer, not shown, is not disposed below the reference plate 53 because there is a space limitation inside the measurement stage body 46. As described above, the aerial image measuring instrument 55 is disposed below the reference plate 53, except for the photoelectric transducer, not shown, and also disposed near the reflection surface 51X to which the beam from the X-axis interferometer 42 is projected and the reflection surface 50 to which the beam from the Y-axis interferometer 44 is projected.

The aerial image measuring instrument 55 condenses the exposure light passed through the first reference mark FM1 formed in the reference plate 53 using the condenser lens 56, guides the condensed exposure light to the position of the photoelectric transducer using the optical fiber 57, and photoelectrically converts the exposure light guided using the optical fiber 57, thereby measuring the light intensity of the aerial image (projection image) of the pattern projected using the projection optical system PL. When the instrument measures baseline values, the first reference marks FM11 and FM12 are used. In other words, the first reference marks FM11 and FM12 are respectively disposed at positions to which the images of a pair of reticle alignment marks formed on the reticle R using the projection optical system PL are projected, and the change in the amount of received light when the measurement stage MST is moved is measured using the aerial image measuring instrument 55. The details of the measurement of the baseline values will be described later.

Furthermore, on the measurement table MTB, a slit opening 58 is formed near the end portion in the -Y direction and away from the reference plate 53; and below the opening 58 (in the -Z direction), a wavefront aberration measuring instrument 59 is disposed. This wavefront aberration measuring instrument 59 is equipped with a light-receiving element, such as a microlens array with a CCD, divides the wavefront of the exposure light passed through the slit opening 58 via the projection optical system PL, and measures the wavefront aberration of the projection optical system PL depending on the image formation position of each divided wavefront on the light-receiving element. As the wavefront aberration measuring instrument 59, for example, the wavefront aberration measuring instrument disclosed in PCT International Patent Publication No. WO 99/60631 (corresponding European Patent No. 1,079,223) can be used.

The reason why the slit opening 58 and the wavefront aberration measuring instrument 59 are disposed near the end portion of the measurement table MTB in the -Y direction is to make the Y-direction length of the measurement table MTB as short as possible, as in the reason why the above-mentioned second reference mark FM2 is disposed near the end portion of the measurement table MTB in the -Y direction. In other words, the measurement of the wavefront aberration of the projection optical system PL is required to be carried out in a state in which the position of the slit opening 58 inside the XY plane is grasped accurately. Therefore, before the measurement of the wavefront aberration, it is necessary to dispose the slit opening 58 below the alignment system 45 (see FIG. 1) and to measure the mark 60 that is formed near the slit opening 58 while having a predetermined positional relationship therewith.

At this time, for the purpose of receiving the water supplied between the front lens GL of the projection optical system PL and the measurement table MTB using the measurement table MTB, the length from the position at which the slit opening 58 is formed to the end portion of the measurement table MTB in the -Y direction is required to be equal to at least the distance between the alignment system 45 and the area to which water is supplied. Therefore, the slit opening 58 and the wavefront aberration measuring instrument 59 are disposed nearest the end portion of the measurement table MTB in the +Y direction to make the Y-direction length of the measurement table MTB as short as possible. Furthermore, the reason why the wavefront aberration measuring instrument 59 is disposed away from the reference plate 53 is to avoid thermal influence on the reference plate 53 as much as possible.

Furthermore, on the measurement table MTB, a pinhole opening pattern 61 is formed at a position away from the reference plate 53 and nearest the end portion thereof in the -X direction; and below this pinhole 61 (in the -Z direction), an exposure detector 62 serving as a detector for detecting information (light amount, illuminance, illuminance irregularity, etc.) regarding the exposure energy of the exposure light irradiated onto the measurement table MTB via the projection optical system PL is disposed. In other words, the exposure detector 62 is disposed at a position farther from the reflection surface 51X to which the beam from the X-axis interferometer 42 is projected and the reflection surface 50 to which the beam from the Y-axis interferometer 44 is projected, than the aerial image measuring instrument 55. As the above-mentioned exposure detector 62, for example, the illuminance irregularity measuring instrument disclosed in Japanese Unexamined Patent Application, Publication No. S57-117238 (corresponding U.S. Patent No. 4,465,368) and the illuminance monitor disclosed in Japanese Unexamined Patent Application, Publication No. H11-16816 (corresponding U.S. Patent Publication No. 2002/0061469) can be used.

The reason why the exposure detector 62 is disposed at a position farther from the reflection surface 51X and the reflection surface 50 than the aerial image measuring instrument 55 is to avoid a state in which the measurement table MTB thermally expands owing to heat generated by the exposure detector 62, the relative positional relationship between the reflection surface 51X and the reflection surface 50 and the first reference mark FM1 and the second reference mark FM2 changes, and the baseline values have measurement errors or the like. Furthermore, there is a reason due to wiring because the wires connected to the exposure detector 62 are drawn out from the -Y side face of the measurement stage body 46 to the outside. In FIG. 7, the aerial image measuring instrument 55, the wavefront aberration measuring instrument 59 and the exposure detector 62 described above are shown as an instrument group 63.

Returning to FIG. 1, the off-axis type alignment system 45 provided on a holding member for holding the projection unit PU measures the position of target marks (the alignment mark formed on the wafer W, the second reference mark FM2 formed on the reference plate 53, the mark 60 formed on the measurement table MTB, etc.). The alignment system 45 is an FIA (Field Image Alignment) alignment sensor utilizing an image processing system in which a broadband detection beam that does not expose the resist on the wafer W is directed to each of the target marks, the image of the target mark formed on the light-receiving face using the light reflected from the target mark and the image of an indicator (an indicator pattern on an indicator plate provided inside the alignment system 45), not shown, are taken using an image pickup device (a CCD or the like), and then their imaging signals are output. The imaging signals from the alignment system 45 are supplied to the main control unit 20 shown in FIG. 7.

Furthermore, the exposure apparatus EX according to this embodiment is provided with a focal position detection system including an illumination system 64a and a light-receiving system 64b (see FIG. 7), not shown in FIG. 1. This focal position detection system is, for example, the detection system disclosed in Japanese Unexamined Patent Application, Publication No. H6-283403 (corresponding U.S. Patent No. 5,448,332). The illumination system 64a directs detection light obliquely to each of multiple detection points set inside the exposure area (the projection area of the projection optical system PL), and the light-receiving system 64b receives the reflected light thereof, thereby detecting the position and attitude (the rotation around the X-axis and the Y-axis) of the wafer W in the Z direction, for example.

FIG. 7 is a block diagram showing the configuration of the control system of the exposure apparatus EX. The control system shown in FIG. 7 mainly includes the main control unit 20 consisting of a microcomputer (or a workstation) for carrying out centralized control for the overall operation of the exposure apparatus EX. In addition, to the main control unit 20, a memory 65 and a display 66, such as a CRT (Cathode Ray Tube) display (or a liquid crystal display), are connected. The memory 65 stores information required for controlling the operation of the exposure apparatus EX, such as baseline values, shot arrangement obtained by the EGA operation and the history of exposure amounts, and the display 66 displays various information, such as information indicating the state of the exposure apparatus EX and error information, output from the main control unit 20.

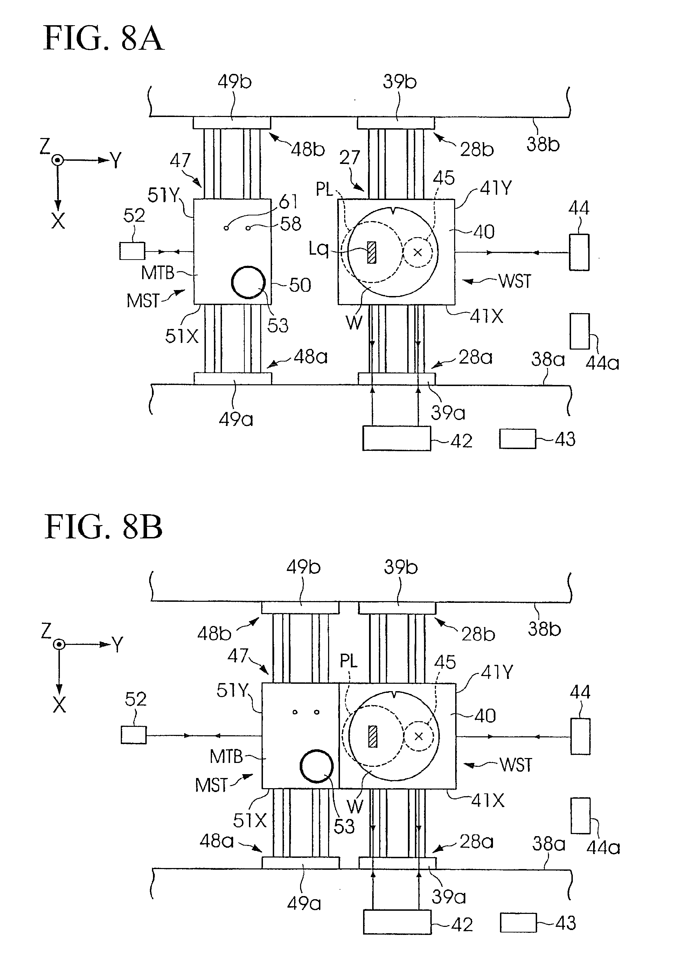

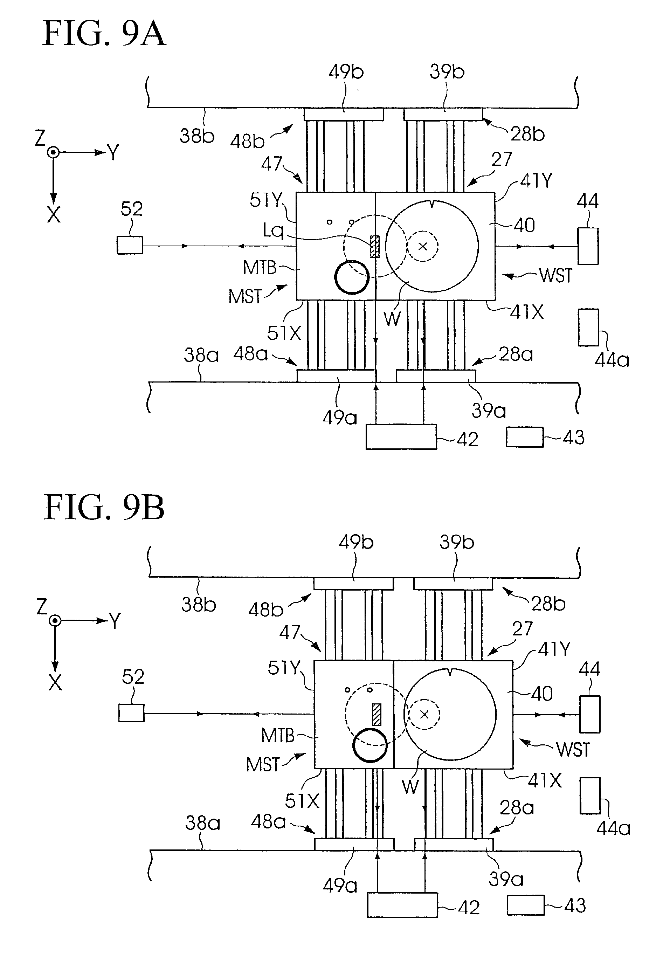

Next, the parallel processing of the wafer stage WST and the measurement table MTB in the exposure apparatus EX configured as described above will be described. FIGS. 8A and 8B and FIGS. 9A and 9B are plan views illustrating the parallel processing of the wafer stage WST and the measurement table MTB. In the operations described below, the valves of the liquid supply unit 19a and the liquid recovery unit 19b of the liquid immersion unit 17 are open/close-controlled using the main control unit 20 as described above, and the space directly below the front lens GL of the projection optical system PL is filled with water at all times. However, in the descriptions given below, descriptions regarding the control of the liquid supply unit 19a and the liquid recovery unit 19b are omitted for the sake of facilitating description.

FIG. 8A is a plan view showing a state in which step-and-scan type exposure is carried out for the wafer W (the last wafer of one lot in this case) held on the wafer stage WST. As shown in FIG. 8A, the wafer stage WST is disposed below the projection optical system PL (in the -Z direction), and the measurement stage MST stands by at a predetermined standby position in the -Y direction so as not to collide (make contact) with the wafer stage WST. Under the control of the main control unit 20, the exposure operation for the wafer W is carried out by repeating intershot movement for moving the wafer stage WST to a scanning start position (acceleration start position) for exposure of each shot area on the wafer W and scanning exposure operation for transferring the pattern formed on the reticle R to each shot area using the scanning exposure system on the basis of the results of wafer alignment, such as enhanced global alignment (EGA), and the newest measurement results of the baseline values of the alignment system 45, conducted in advance.

In addition, together with the wafer alignment, focal position detection for the wafer W is carried out using a focal position detection system, not shown, including the illumination system 64a and the light-receiving system 64b, and the surface of the wafer W is positioned at the focal position of the projection optical system PL. The focal position with respect to the wafer W, that is, the position to which the detection light from the illumination system 64a is projected, is set at the position not filled with water Lq. The focal position detection for a shot area (first shot area) to be subjected to exposure processing is first carried out at a position before this shot area is immersed in water Lq. Even while the exposure processing for the first shot area is carried out, the projection of the detection light from the illumination system 64a continues, and focal position information on the shot area to which the detection light is projected is collected. Next, after exposure processing for the first shot area is completed and when exposure processing for the next shot area (second shot area) is carried out, the surface of the second shot area is positioned at the focal position of the projection optical system PL according to the focal position information collected during the exposure processing for the first shot area. As described above, for the second shot area and the following shot areas, positioning to the focal position of the projection optical system PL is carried out according to the focal position information detected and collected during the exposure processing previously carried out. In other words, since it is not necessary to separately provide a process for detecting the focal position information, throughput can be improved.

The intershot movement operation in which the wafer stage WST is moved as described above is carried out such that the main control unit 20 controls the driving of the first drive system 27 and the second drive systems 28a and 28b provided for the wafer stage WST while monitoring the detected values of the X-axis interferometer 42 and the Y-axis interferometer 44. Furthermore, the above-mentioned scanning exposure is attained such that the main control unit 20 controls the driving of the reticle stage drive section 11, the first drive system 27 and the second drive systems 28a and 28b while monitoring the detected values of the X-axis interferometer 42, the Y-axis interferometer 44 and the laser interferometer 12 so that the reticle R (reticle stage RST) and the wafer W (wafer stage WST) are relatively scanned in the Y direction and so that the reticle R (reticle stage RST) and the wafer W (wafer stage WST) are moved synchronously at equal speed in the Y direction with respect to the illumination area of the illumination light IL in the constant-speed movement period between the time after the end of acceleration and the time immediately before the start of deceleration during the scanning. The above-mentioned exposure operation is carried out in a state in which water Lq is held in the space between the front lens GL and the wafer W.

When the exposure to the wafer W held on the wafer stage WST is completed, the main control unit 20 controls the driving of the first drive system 47 and the second drive systems 48a and 48b provided for the measurement stage MST on the basis of the detected values of the Y-axis interferometer 52 to move the measurement stage MST (measurement table MTB) to the position shown in FIG. 8B. FIG. 8B is a view showing a state in which the +Y side face of the measurement table MTB makes contact with the -Y side face of the wafer holder 40 (auxiliary plate). In the example shown in FIGS. 8A and 8B, the X direction position of the measurement stage MST is not detected until the measurement table MTB makes contact with the wafer holder (auxiliary plate). In this state, it is desirable that an auxiliary laser interferometer for detecting the X direction position of the measurement table MTB be provided. Furthermore, the case in which the +Y side face of the measurement table MTB makes contact with the -Y side face of the wafer holder (auxiliary plate) is taken as an example and described herein. However, the measurement table MTB and the wafer table WTB may be maintained in a non-contact state so as to be separated from each other by a distance of, for example, approximately 300 µm (a clearance through which water leakage due to surface tension does not occur) in the Y direction while the measured values of the interferometers 44 and 52 are monitored.

Next, the main control unit 20 starts the operation for driving the two stages WST and MST in the +Y direction while the Y direction positional relationship between the wafer table WTB and the measurement table MTB is maintained. When the wafer stage WST and the measurement table MTB are driven simultaneously using the main control unit 20 as described above, in the state shown in FIG. 8B, the water Lq held between the front lens GL provided for the projection unit PU and the wafer W is moved onto the wafer W, the wafer holder 40 and the measurement table MTB sequentially as the wafer stage WST and the measurement stage MST are moved in the +Y direction. During the above-mentioned movement, the positional relationship in which the wafer table WTB and the measurement table MTB are in contact with each other is maintained.

FIG. 9A is a view showing a state in which the water Lq exists simultaneously on the wafer stage WST (wafer holder 40) and the measurement stage MST, that is, a state just before the water is transferred from the upper face of the wafer stage WST (wafer holder 40) to the upper face of the measurement stage MST while the wafer table WTB and the measurement table MTB are moved in the +Y direction. When the wafer stage WST and the measurement stage MST are further driven simultaneously by a predetermined distance in the +Y direction from the state shown in FIG. 9A, the water is held between the measurement stage MST and the front lens GL as shown in FIG. 9B. Prior to this state, the main control unit 20 resets the X-axis interferometer 42 at any time when the interferometer beam from the X-axis interferometer 42 is ready to be directed to the reflection surface 51X of the measurement table MTB. Furthermore, in the state shown in FIG. 9B, the main control unit 20 controls the X position of the wafer table WTB (wafer stage WST) on the basis of the measured values of the X-axis interferometer 43.

Next, the main control unit 20 controls the driving of the first drive system 27 and the second drive systems 28a and 28b provided for the wafer stage WST while controlling the position of the wafer stage WST on the basis of the detected values of the X-axis interferometer 43 and the Y-axis interferometer 44a, thereby moving the wafer stage WST to the predetermined loading position, and replacing the wafer with the first wafer of the next lot. In parallel with this, predetermined measurements using the measurement stage MST are carried out as necessary. As these measurements, the measurement of the baseline values of the alignment system 45, being carried out after the replacement of the reticle on the reticle stage RST, is taken as an example. Although the X direction loading position is on the side of the stator 38a in this embodiment, the X direction loading position may be on the side of the stator 38b.

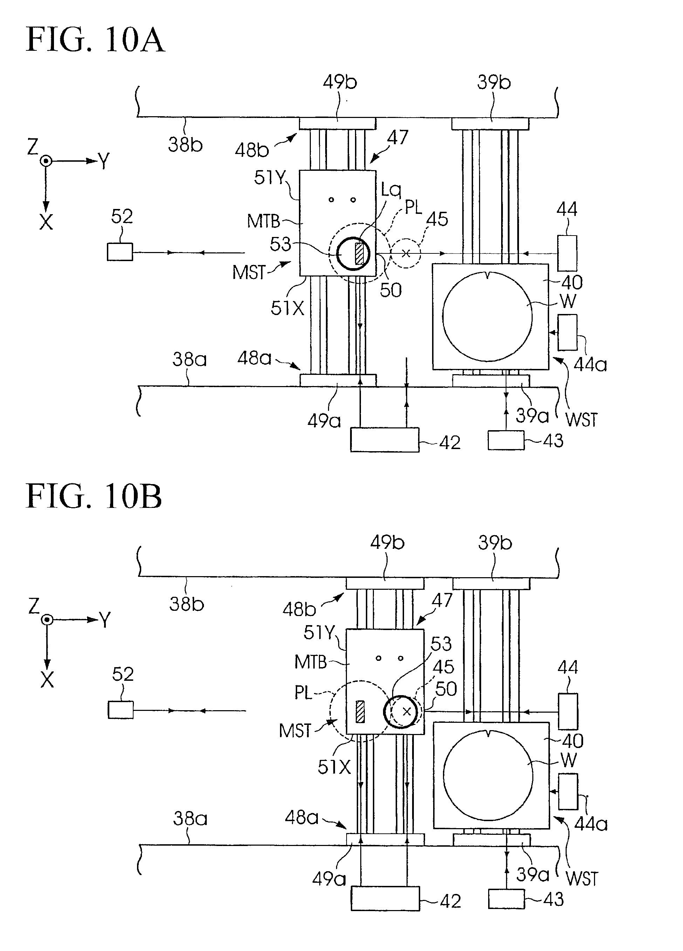

FIGS. 10A and 10B are plan views showing the positional relationship between the wafer stage WST and the measurement stage MST at the time of measuring baseline values. When the wafer stage WST is disposed at the loading position, the beam from the Y-axis interferometer 44 is directed to the reflection surface 50 provided for the measurement table MTB as shown in FIG. 10A. Therefore, the main control unit 20 controls the driving of the first drive system 47 and the second drive systems 48a and 48b provided for the measurement stage MST while monitoring the detected values of the X-axis interferometer 42 and the Y-axis interferometer 44, thereby positioning the reference plate 53 below the projection optical system PL. The specific position at which the reference plate 53 is positioned is the position at which the image of the reticle alignment mark formed on the reticle R is projected using the projection optical system PL or the position adjacent thereto at which each of the first reference marks FM11 and FM12 (see FIG. 4) is disposed as shown in FIG. 10A. Although the beam from the Y-axis interferometer 52 is also directed to the reflection surface 51 Y provided for the measurement table MTB, the Y-axis interferometer 44 for detecting the Y direction position of the wafer stage WST is used to detect the Y direction position of the measurement table MTB so that errors in the baseline values due to scaling errors between the Y-axis interferometer 44 and the Y-axis interferometer 52 are avoided.

After the positioning of the reference plate 53 is completed, the illumination light IL from the illumination optical system ILS is directed to the reticle alignment mark, and its image is projected onto the first reference marks FM11 and FM12 being positioned or to the position adjacent thereto via the projection optical system PL and the water Lq. The beams having passed through the first reference marks FM11 and FM12 are condensed using the condenser lens 56 provided for the aerial image measuring instrument 55 shown in FIG. 6, guided to the photoelectric transducer, not shown, via the optical fiber 57, and received. At this time, a detection signal having a signal intensity corresponding to the amount of overlap between the reticle alignment mark and the first reference marks FM11 and FM12 is output from the photoelectric transducer to the main control unit 20. The main control unit 20 minutely drives the measurement stage MST inside the XY plane while monitoring the detected values of the X-axis interferometer 42 and the Y-axis interferometer 44, and obtains the projection center of the projection optical system PL inside the wafer stage coordinate system being set for the wafer stage WST, on the basis of the change in the detection signal of the photoelectric transducer provided for the aerial image measuring instrument 55 and the detection results of the X-axis interferometer 42 and the Y-axis interferometer 44. Therefore, the positional relationship between the image projected using the projection optical system PL and the wafer stage WST is obtained.

Next, the main control unit 20 controls the driving of the first drive system 47 and the second drive systems 48a and 48b provided for the measurement stage MST while monitoring the detected values of the X-axis interferometer 42 and the Y-axis interferometer 44, and positions the reference plate 53 below the alignment system 45. The specific position at which the reference plate 53 is positioned is the position at which the second reference mark FM2 (see FIG. 4) formed on the reference plate 53 is disposed in the measurement view of the alignment system 45 as shown in FIG. 10B. When the positioning of the reference plate 53 is completed, the position of the second reference mark FM2 is measured using the alignment system 45, and the main control unit 20 obtains the center of the measurement view of the alignment system 45 inside the wafer stage coordinate system on the basis of the measurement results of the alignment system 45 and the detection results of the X-axis interferometer 42 and the Y-axis interferometer 44. Next, the main control unit 20 calculates the baseline values on the basis of the projection center of the projection optical system PL and the center of the measurement view of the alignment system 45 inside the wafer stage coordinate system obtained as described above, and stores the obtained baseline values in the memory 65 (see FIG. 7).

Together with the above-mentioned measurement of the baseline values using the alignment system 45, using multiple reticle alignment marks formed on the reticle R and the total six first reference marks FM1 (see FIG 4) formed so as to correspond thereto, the measurement of the relative positions of the reticle alignment marks corresponding to at least two pairs of first reference marks FM1 is carried out using the reticle alignment detection systems 14a and 14b while at least one of the reticle stage RST and the wafer stage WST is moved stepwise in the Y direction, whereby so-called reticle alignment is carried out. In this case, the mark detection using the reticle alignment detection systems 14a and 14b is carried out via the projection optical system PL and the water Lq.

When the replacement of the wafer W on the wafer stage WST and the measurement using the measurement stage MST described above are completed, the main control unit 20 makes the measurement stage MST contact the wafer stage WST, drives them inside the XY plane while the contact state is maintained, and returns the wafer stage WST just below the projection unit PU. During this movement, the main control unit 20 resets the X-axis interferometer 42 at any time when the beam from the X-axis interferometer 42 is ready to be directed to the reflection surface 41 X of the wafer table WTB. In the state in which the measurement stage MST is in contact with the wafer stage WST, the beam from the Y-axis interferometer 44 is directed to the reflection surface 41Y In addition, on the side of the wafer stage WST, wafer alignment is carried out for the replaced wafer W. In other words, the alignment marks on the replaced wafer are detected using the alignment system 45, and the position coordinates of multiple shot areas on the wafer W are calculated by the EGA operation.

Then, while the positional relationship between the wafer stage WST and the measurement stage MST in the Y direction is maintained, in a way opposite of that described above, the main control unit 20 simultaneously drives the wafer stage WST and the measurement stage MST in the -Y direction to move the wafer stage WST (wafer W) below the projection optical system PL and then to retreat the measurement stage MST to a predetermined position. Furthermore, the main control unit 20 carries out a step-and-scan type exposure operation for a new wafer in a way similar to that described above, whereby the reticle pattern is transferred sequentially to the multiple shot areas on the wafer.

In the above-mentioned descriptions, the case in which baseline measurement is carried out as measurement operation is described. However, without being limited to this, it may also be possible that while the wafer replacement is carried out on the side of the wafer stage WST, aerial image measurement is carried out using the aerial image measuring instrument 55 provided for the measurement stage MST, wavefront aberration measurement is carried out using the wavefront aberration measuring instrument 59, or illuminance measurement, illuminance irregularity measurement, etc., is carried out using the exposure detector 62, and the measurement results are fed back to the exposure of the wafer W to be carried out thereinafter. More specifically, for example, the optical characteristics of the projection optical system PL can be adjusted using the above-mentioned imaging characteristic correction controller 16 on the basis of the results of the measurements.

As described above, in the measurement stage MST according to this embodiment, the aerial image measuring instrument 55 and the second reference mark FM2 for measuring the positional relationship of the wafer stage WST with respect to the projection image of the pattern are disposed near the reflection surface 51X to which the beam from the X-axis interferometer 42 is projected and the reflection surface 50 to which the beam from the Y-axis interferometer 44 is projected; therefore, measurement errors and the like in the baseline values due to thermal expansion of the measurement table MTB can be prevented from occurring. In addition, the exposure detector 62 that generates heat is disposed at a position farther from the reflection surface 51X and the reflection surface 50 than the aerial image measuring instrument 55. Therefore, this can also prevent measurement errors and the like from occurring in the baseline values due to thermal expansion of the measurement table MTB. Furthermore, a temperature controller for cooling the exposure detector may also be provided to further reduce the measurement errors and the like of the baseline values.

In addition, the measurement table MTB can be prevented from becoming larger in size by disposing the aerial image measuring instrument 55 and the second reference mark FM2 on the end portion side on which the reflection surface 50 is provided. Furthermore, since the measurement table MTB is made replaceable from the measurement stage body 46, replacement of the measurement table MTB or the like can be carried out before measurement errors occur in the readings of various measuring instruments owing to a deterioration in water repellency or the like on the surface of the measurement table MTB. Since the reference plate 53 is provided on the measurement table MTB so as to be replaceable from the measurement table MTB, only the component that is required to have high measurement accuracy can be replaced in a short time.

Although an embodiment according to the present invention has been described above, the present invention is not limited to the above-mentioned embodiment but can be used for an exposure apparatus that does not use the liquid immersion method. In addition, although a case in which the ArF excimer laser beam is used is taken as an example in the above-mentioned embodiment and described, in addition to this, it is possible to use, for example, g-rays (wavelength: 436 nm), i-rays (wavelength: 365 nm), a Krf excimer laser beam (wavelength: 248 nm), a F₂ laser beam (wavelength: 157 nm), a Kr₂ laser beam (wavelength: 146 nm), a YAG laser beam, or the high-frequency wave of a semiconductor laser. Furthermore, it may also be possible to use the harmonics obtained by amplifying a laser beam having a single wavelength in an infrared region or a visible region oscillated from a DFB semiconductor laser or a fiber laser using a fiber amplifier doped with, for example, erbium (or both erbium and yttrium) and by transforming the wavelength to ultraviolet light using a non-linear optical crystal. For example, if the oscillation wavelength of a single wavelength laser is in the range of 1.51 to 1.59 µm, the eighth harmonic that generates wavelengths in the range of 189 to 199 nm or the tenth harmonic that generates wavelengths in the range of 151 to 159 nm is output.

In addition, the present invention is also applicable to a twin-stage type exposure apparatus that is provided with multiple wafer stages. The structure and exposure operation of the twin-stage type exposure apparatus are disclosed in, for example, Japanese Unexamined Patent Application, Publication No. H10-163099 and Japanese Unexamined Patent Application, Publication No. H10-214783 (corresponding U.S. Patent No. 6,341,007, No. 6,400,441, No. 6,549,269 and No. 6,590,634), Japanese Translation of PCT International Application No. 2000-505958 (corresponding U.S. Patent No. 5,969,441) or U.S. Patent No. 6,208,407. Furthermore, the present invention may be applied to the wafer stage disclosed in Japanese Patent Application No. 2004-168481 applied earlier by the applicant of the present invention.

As the substrate being held on the movement stage in each embodiment described above, not only semiconductor wafers for manufacturing semiconductor devices but also glass substrates for display devices, ceramic wafers for thin film magnetic heads, masks, or original plates (synthetic quartz, silicon wafers) of reticles being used for exposure apparatuses are applicable. As the exposure apparatus EX, the present invention is also applicable to a scanning type exposure apparatus that does not use the liquid immersion method and a step-and-repeat type projection exposure apparatus (stepper) in which the pattern of the reticle R is one-shot exposed while the reticle R and the wafer W are made stationary, and then the wafer W is moved stepwise sequentially. Furthermore, the present invention is also applicable to a step-and-stitch type exposure apparatus in which at least two patterns are partially overlaid on the wafer W and transferred. As the type of the exposure apparatus EX, the present invention is applicable widely to not only exposure apparatuses for manufacturing semiconductor devices, in which semiconductor device patterns are exposed on the wafer W, but also exposure apparatuses for manufacturing liquid crystal display devices or displays, and exposure apparatuses for manufacturing thin film magnetic heads, image pickup devices (CCDs), reticles or masks.

When linear motors are used for the wafer stage WST or the reticle stage RST (refer to USP NO. 5,623,853 or USP NO. 5,528,118), either an air-floating type using air bearings or a magnetic suspension type using the Lorentz force or reactance force may be used. In addition, each of the stages WST and RST may be a type that moves along a guide or a guideless type provided with no guide. As the drive mechanism for each of the stages WST and RST, it may be possible to use a planar motor in which a magnet unit including magnets disposed two-dimensionally and an armature unit including coils disposed two-dimensionally are opposed to each other and an electromagnetic force is used to drive each of the stages WST and RST. In this case, either one of the magnet unit and the armature unit should only be connected to each of the stage WST and RST, and the other, that is, the magnet unit or the armature unit, should only be provided on the movement face side of each of the stage WST and RST.

The reaction force generated by the movement of the wafer stage WST may be released mechanically to the floor (ground) using frame members as described in Japanese Unexamined Patent Application, Publication No. H08-166475 (U.S. Patent No. 5,528,118) so as not to be transmitted to the projection optical system PL. The reaction force generated by the movement of the reticle stage RST may be released mechanically to the floor (ground) using frame members as described in Japanese Unexamined Patent Application, Publication No. H08-330224 (US S/N08/416,558) so as not to be transmitted to the projection optical system PL.

As described above, the exposure apparatus EX according to the embodiment is manufactured by assembling various subsystems including various components so that predetermined mechanical precision, electrical precision and optical precision are maintained. For the purpose of securely obtaining these various precisions, before and after this assembly, adjustments for attaining the optical precision are carried out for various optical systems, adjustments for attaining the mechanical precision are carried out for various mechanical systems, and adjustments for attaining the electrical precision are carried out for various electrical systems. The process for assembling an exposure apparatus from the various subsystems includes mutual mechanical connections of various subsystems, wiring connections of electrical circuits, piping connections of pneumatic circuits, etc. It is a matter of course that a process of assembling each subsystem is carried out before the process for assembling the exposure apparatus from the various subsystems. After the process of assembling the exposure apparatus from the various subsystems is completed, comprehensive adjustments are performed, and the various precisions for the overall exposure apparatus are obtained securely. It is preferable that the manufacturing of the exposure apparatus should be carried out in a clean room in which the temperature, the degree of cleanness, etc., are controlled.

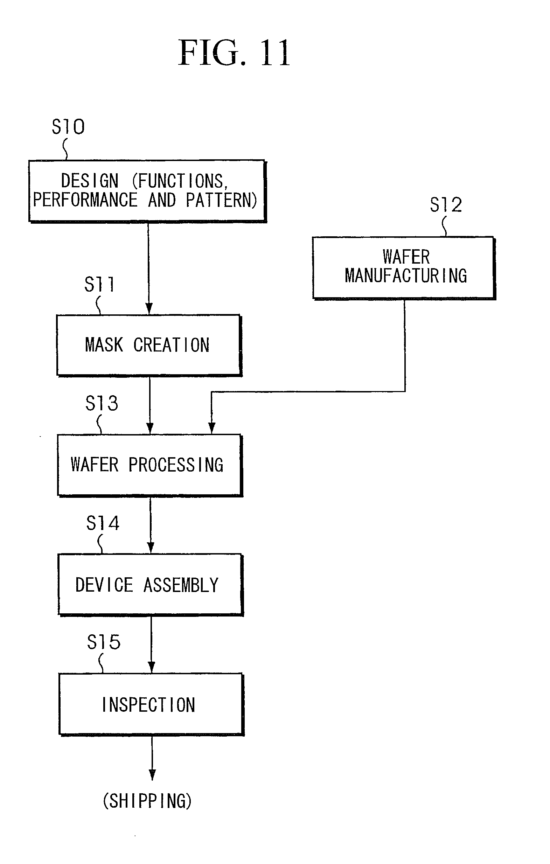

FIG. 11 is a flowchart showing an example of a process for manufacturing micro devices (semiconductor chips, such as ICs and LSIs, liquid crystal display panels, CCDs, thin film magnetic heads, micro machines, etc.). As shown in FIG. 11, micro devices, such as semiconductor devices, are manufactured through step S 10 for carrying out function/performance design of the micro devices, step S 11 for creating a mask (reticle) based on this design step, step S 12 for manufacturing a substrate (wafer) serving as the base material of the device, wafer processing step S 13 for transferring the pattern of the mask to the substrate using the exposure apparatus EX according to the above-mentioned embodiment, device assembling step S 14 (including a dicing process, a bonding process and a packaging process), inspection step S15, etc.

## Claims

1. An exposure apparatus that exposes a substrate mounted on a movable substrate stage with a pattern via a projection optical system, comprising:
a measurement stage being movable independent of the substrate stage; and
a position detector that directs a beam to a reflection member provided on the measurement stage and detects the position of the measurement stage, wherein
an aerial image measuring instrument that measures an aerial image projected using the projection optical system and a reference mark for measurement of the positional relationship of the substrate stage with respect to the projection image of the pattern are disposed adjacent to the reflection member of the measurement stage.

2. An exposure apparatus according to claim 1, wherein a detector that detects information regarding exposure energy is disposed on the measurement stage farther from the reflection member than the aerial image measuring instrument.

3. An exposure apparatus according to claim 1 or 2, wherein
the measurement stage moves in a two-dimensional plane,
the reflection member comprises a first reflection member formed in a first direction and a second reflection member formed in a second direction intersecting the first direction, and
the aerial image measuring instrument is provided adjacent to the first reflection member and the second reflection member.

4. An exposure apparatus according to claim 3, wherein the reflection member has a third reflection member provided in the first direction substantially parallel with the first reflection member.

5. An exposure apparatus that exposes a substrate mounted on a movable substrate stage with a pattern via a projection optical system, comprising:
a measurement stage being movable independent of the substrate stage;
a detector that is provided on the measurement stage and detects information regarding exposure energy; and
a position detector that directs a beam to a reflection member provided on the measurement stage and detects the position of the measurement stage, wherein
an aerial image measuring instrument that measures an aerial image projected using the projection optical system is disposed on the measurement stage closer to the reflection member than the detector.

6. An exposure apparatus that exposes a substrate mounted on a movable substrate stage with a pattern via a projection optical system, comprising:
a measurement stage being movable independent of the substrate stage;
an aberration detector that is provided on the measurement stage and detects the aberration information of the projection optical system; and
a position detector that directs a beam to the reflection member provided on the measurement stage and detects the position of the measurement stage, wherein
an aerial image measuring instrument that measures an aerial image projected using the projection optical system is disposed on the measurement stage closer to the reflection member than the aberration detector.

7. An exposure apparatus according to any one of claims 1 to 6, wherein at least a part of the measurement stage has a replaceable plate portion.

8. An exposure apparatus according to claim 7, wherein the aerial image measuring instrument has a replaceable measurement pattern portion at the plate portion.

9. An exposure apparatus according to claim 7 or 8, wherein at least a part of the plate portion is made of a low thermal expansion material.

10. An exposure apparatus according to any one of claims 1 to 9, wherein the aerial image measuring instrument measures the aerial image via a liquid.

11. An exposure apparatus according to any one of claims 1, 5 and 6, wherein the reference mark is formed on a circular member.

12. An exposure apparatus according to any one of claims 1, 5 and 6, further comprising an alignment system having a view center being away from the projection center of the projection optical system, wherein the alignment system detects the reference mark without using liquid.

13. An exposure apparatus according to claim 7, wherein at least a part of the plate portion is subjected to liquid repellency treatment.

14. An exposure apparatus according to any one of claims 1, 5 and 6, wherein the position detector detects the position of the substrate stage during the exposure.

15. A device manufacturing method including a process for transferring the pattern of a device onto a substrate using the exposure apparatus according to any one of claims 1 to 14.
